# EUROPÄISCHE PATENTSCHRIFT

(11) **EP 3 861 401 B1**
(45) Veröffentlichungstag und Bekanntmachung des Hinweises auf die Patenterteilung: **01.10.2025**
(21) Anmeldenummer: 19759516.8
(22) Anmeldetag: 14.08.2019
(51) Int. Cl.: G02B 27/64, H05G 2/00, G01S 3/784

(54) **VORRICHTUNG UND VERFAHREN ZUR STRAHLWINKELMESSUNG EINES VON EINER STRAHLFÜHRUNGSOPTIK GEFÜHRTEN LICHTSTRAHLS**
DEVICE AND METHOD FOR MEASURING THE BEAM ANGLE OF A LIGHT BEAM GUIDED BY A BEAM GUIDING OPTICAL UNIT
DISPOSITIF ET PROCÉDÉ DE MESURE D'ANGLE D'UN RAYON LUMINEUX GUIDÉ PAR UNE OPTIQUE DE GUIDAGE DE RAYON

(30) Priorität: 02.10.2018 DE 102018124342
(43) Veröffentlichungstag der Anmeldung: 11.08.2021
(73) Patentinhaber: Carl Zeiss SMT GmbH, 73447 Oberkochen (DE)
(72) Erfinder: BAUMER, Florian, 73447 Oberkochen (DE); MANGER, Matthias, 73432 Aalen (DE)
(74) Vertreter: Frank, Hartmut
(86) Internationale Anmeldenummer: PCT/EP2019/071811
(87) Internationale Veröffentlichungsnummer: WO 2020/069793

(56) Entgegenhaltungen:
- DE-A1- 102010 050 947
- DE-A1- 102014 203 141

## Beschreibung

Die vorliegende Anmeldung beansprucht die Priorität der Deutschen Patentanmeldung DE 10 2018 124 342.1, angemeldet am 2. Oktober 2018.

### HINTERGRUND DER ERFINDUNG

### Gebiet der Erfindung

Die Erfindung betrifft eine Steuerungseinrichtung für einen Lichtstrahl und ein Verfahren zur Strahlwinkelmessung eines von einer Strahlführungsoptik geführten Lichtstrahls.

Die Erfindung ist insbesondere bei der Überwachung eines Anregungs-Laserstrahls in einer EUV-Plasmaquelle vorteilhaft einsetzbar. Anwendungen der Erfindung sind jedoch nicht hierauf beschränkt, sondern umfassen insbesondere sämtliche Anwendungen, bei denen eine möglichst schnelle Positionserfassung und -kontrolle eines Lichtstrahls bzw. Laserstrahls, beispielsweise bei der Materialbearbeitung oder der Lagebestimmung von Objekten relativ zur Fokuslage einer Abbildungsoptik, gewünscht ist.

### Stand der Technik

Bekannte Ansätze zur Strahlwinkelmessung bzw. Erfassung der Ausbreitungsrichtung eines Lichtstrahls umfassen neben kamerabasierten Ansätzen insbesondere den Einsatz von Lichtintensitätssensor-Anordnungen in Form kommerziell erhältlicher Quadrantendetektoren.

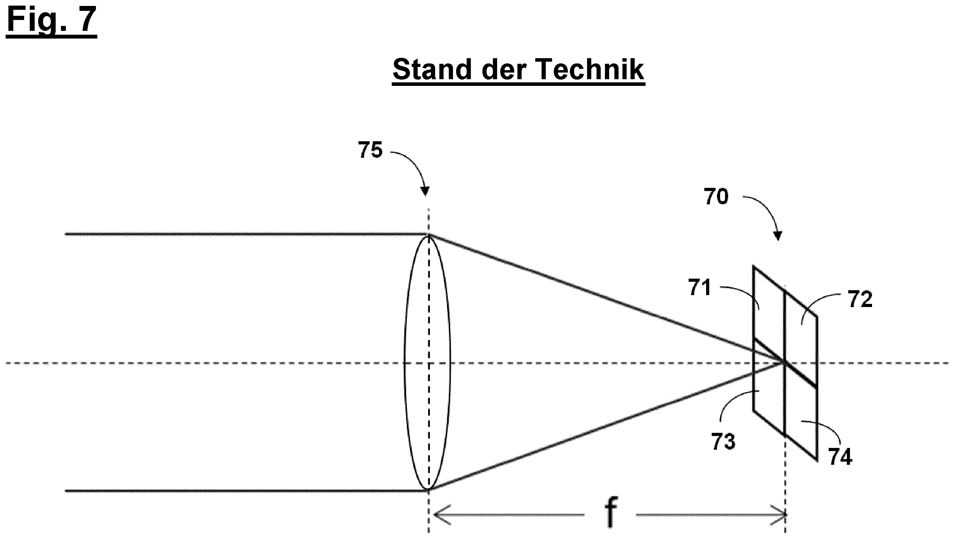

Fig. 7 zeigt in lediglich schematischer Darstellung einen prinzipiell möglichen Messaufbau. Dabei wird ein hinsichtlich seiner Ausbreitungsrichtung bzw. seines Strahlwinkels zur optischen Systemachse zu vermessender Lichtstrahl über eine Fokussiereinheit 75 auf einen in der bildseitigen Brennebene dieser Fokussiereinheit 75 angeordneten Quadrantendetektor 70 fokussiert. Der Quadrantendetektor 70 ist aus vier Lichtintensitätssensoren 71-74 zusammengesetzt, wobei der gesuchte Strahlwinkel bzw. die Ausbreitungsrichtung des Lichtstrahls aus Verrechnung der mit diesen Lichtintensitätssensoren 71-74 gemessenen Lichtintensitäten bestimmt wird. Die Anordnung des Quadrantendetektors 70 im Brennweitenabstand der Fokussiereinheit 75 hat dabei den Vorteil, dass das Messsignal insensitiv auf eine Lateralverschiebung des zu messenden Laserstrahls ist und somit tatsächlich nur die Strahlausbreitungsrichtung gemessen wird. Grundsätzlich können mit halbleiterbasierten Detektoren, wie sie in Quadrantendetektoren zum Einsatz kommen, Messbandbreiten bis in den GHz-Bereich erreicht werden, wohingegen kamerabasierte Detektoren im Infrarotbereich lediglich Messbandbreiten von 1kHz oder weniger erreichen.

Wenngleich das vorstehend beschriebene Messprinzip grundsätzlich eine relativ schnelle Winkel- bzw. Positionserfassung des Lichtstrahls etwa im Vergleich zu kamerabasierten Ansätzen ermöglicht, resultiert in der Praxis ein Nachteil des beschriebenen Messprinzips aus dem vergleichsweise kleinen, durch die Spotgröße des Lichtstrahls auf dem Quadrantendetektor begrenzten Messbereich. Insbesondere hat die Fokussierung des Lichtstrahls vergleichsweise geringe mittlere Strahldurchmesser bzw. Spotgrößen von größenordnungsmäßig weniger als 100µm auf dem Quadrantendetektor zur Folge, so dass bereits bei vergleichsweise geringen Strahlwinkeländerungen ein Herauswandern des Strahls aus dem Zentrum des Quadrantendetektors eintritt und schließlich kein zur Positionsbestimmung verwertbares Messsignal mehr vorliegt, sobald sich der Spot auf nur noch einem der Lichtintensitätssensoren 71-74 befindet.

Ansätze zur Überwindung des vorstehend beschriebenen Problems im Wege einer beugungsbasierten Aufweitung des Lichtstrahls durch Einsatz einer Aperturblende haben wiederum den Nachteil, dass nur ein vergleichsweise kleiner Anteil des Lichtstrahls (von z.B. 10% der Gesamtleistung) zum eigentlichen Messsignal beiträgt mit der Folge, dass dieser Anteil gegebenenfalls nicht mehr hinreichend repräsentativ für den gesamten Lichtstrahl ist und das Messsignal stattdessen z.B. durch lokale Wellenfrontneigungen dominiert wird. Ein weiterer Nachteil des Einsatzes einer Aperturblende ist, dass die Anordnung sensitiv auf eine Lateralverschiebung des Laserstrahls wird, mit anderen Worten also nicht mehr ohne Weiteres unterschieden werden kann, ob eine Spotbewegung auf dem Quadrantendetektor durch eine Änderung der Strahlausbreitungsrichtung oder durch eine Änderung der Lateralposition des Laserstrahls hervorgerufen wird.

Zum Stand der Technik wird beispielhaft auf DE 10 2014 203 141 A1 und DE 10 2012 212 354 A1 verwiesen. DE 10 2010 050947 A1 offenbart eine teuerungseinrichtung für einen Laserstrahl in einer Anlage zur Erzeugung von EUV-Strahlung. ie Steuerungseinrichtung weist eine Strahlfokussiereinheit, einen einstellbaren Spiegel, einen trahlteiler und einen Quadrantendetektor auf.

### ZUSAMMENFASSUNG DER ERFINDUNG

Aufgabe der vorliegenden Erfindung ist es, eine Steuerungseinrichtung sowie ein Verfahren zur Strahlwinkelmessung eines von einer Strahlführungsoptik geführten Lichtstrahls bereitzustellen, welche eine möglichst genaue Strahlwinkelmessung über einen möglichst großen Messbereich unter Vermeidung der vorstehend beschriebenen Nachteile ermöglichen.

Diese Aufgabe wird gemäß den Merkmalen der unabhängigen Patentansprüche gelöst.

Der Erfindung liegt das Konzept zugrunde, bei der Strahlwinkelmessung eines Lichtstrahls im Wege der aktiven Nachführung einer im optischen Strahlengang des Lichtstrahls befindlichen Komponente (bei welcher es sich um die Lichtintensitätssensor-Anordnung selbst, die Fokussiereinheit oder auch um eine im Strahlengang befindliche Umlenkoptik handeln kann) den anzumessenden Lichtstrahl jederzeit im Wesentlichen auf einer vorgegebenen Position der Lichtintensitätssensor-Anordnung zu halten und so Messbereichsbeschränkungen, welche sich aus dem eingangs beschriebenen Problem eines "Herauswanderns" des Lichtstrahls bzw. Laserspots etwa aus dem Zentrum eines Quadrantendetektors ergeben, zu vermeiden. Dabei kann als für die Strahlwinkelbestimmung letztlich relevantes Messsignal das zur besagten Nachführung bzw. für die "Zentrierung der Spotposition" jeweils benötigte Steuersignal herangezogen werden.

Aufgrund der vorstehend beschriebenen Nachführung werden bei dem erfindungsgemäßen Konzept grundsätzlich mechanisch bedingte Beschränkungen hinsichtlich der Regelbandbreite der Nachführung in Kauf genommen (wobei insoweit eine obere Grenze für die mechanische Nachführung im Bereich von 100Hz bis 1kHz liegt).

Hierbei macht sich jedoch die Erfindung in vorteilhafter Weise den Umstand zunutze, dass die erfindungsgemäß letztlich zu messenden bzw. in einer Strahlführungseinheit "herauszuregelnden" Störungen in Position bzw. Strahlrichtung des Lichtstrahls typischerweise einem "1/*f^{α}*-Verhalten" (α ≥ 1) folgen, so dass vergleichsweise kleine Störungen bzw. Amplituden bei relativ hohen Frequenzen auftreten und umgekehrt. Dieser Umstand hat zur Folge, dass zum einen Störeinflüsse großer Amplitude aufgrund der insoweit vergleichsweise niedrigen Frequenzen über die Nachführmechanik erfasst werden können, und zum anderen für Störeinflüsse hoher Frequenz aufgrund der dann vergleichsweise kleinen Amplituden der (wie eingangs beschrieben relativ kleine) Messbereich einer Lichtintensitätssensor-Anordnung in Form eines Quadrantendetektors selbst genutzt werden kann, so dass im Ergebnis der gesamte erforderliche Messbereich über eine hohe Bandbreite (die nur durch die Messbandbreite der eingesetzten Quadrantendetektoren limitiert wird, die z.B. im GHz-Bereich liegen kann) abgedeckt werden kann. Bei der vorstehend beschriebenen zusätzlichen Nutzung des Messbereichs der

Lichtintensitätssensor-Anordnung d.h. des Quadrantendetektors ergibt sich dann das für die Strahlwinkelmessung letztlich relevante Messsignal aus dem zur Nachführung bzw. zur "Zentrierung der Spotposition" auf der Lichtintensitätssensor-Anordnung erforderlichen Steuersignal unter zusätzlicher Berücksichtigung der (Rest-) Abweichung des Spots auf besagter Lichtintensitätssensor-Anordnung bzw. dem Quadrantendetektor vom jeweiligen Zentrum.

Gemäß einer Ausführungsform weist die Lichtintensitätssensor-Anordnung eine Strahlaufteilungseinrichtung zum Aufteilen des Lichtstrahls auf die Lichtintensitätssensoren auf. Die Strahlaufteilungseinrichtung kann insbesondere ein Prisma aufweisen und z.B. in Verbindung mit einem Quadrantendetektor als pyramidenförmiges Prisma ausgestaltet sein.

Durch diese Ausgestaltung kann wie im Weiteren noch näher beschrieben dem Umstand Rechnung getragen werden, dass in einem Quadrantendetektor fertigungsbedingt Spalte zwischen den benachbarten Lichtintensitätssensoren verbleiben, wobei die Abmessungen dieser Spalte typischerweise im Bereich von größenordnungsmäßig (50-100)µm liegen können mit der Folge, dass ohne weitere Maßnahmen ein signifikanter Lichtanteil in besagte Spalte fällt und somit nicht zur Messung beiträgt.

Durch den erfindungsgemäßen Einsatz der o.g. Strahlaufteilungseinrichtung bzw. des Prismas, welches selbst randscharf bearbeitet bzw. poliert werden kann, kann dann erreicht werden, dass die betreffenden Lichtanteile von vorneherein auf die einzelnen Lichtintensitätssensoren der Lichtintensitätssensor-Anordnung verteilt werden und gar nicht erst auf die Spalte fallen, wobei wiederum eine laterale Änderung des Auftrefforts des Lichtstrahls auf der Strahlaufteilungseinrichtung zu einer Änderung der mit den jeweiligen Lichtintensitätssensoren gemessenen Intensitätswerte führt. Bei der vorstehend beschriebenen Ausgestaltung wird dann als vorgegebener Ort auf der Lichtintensitätssensor-Anordnung, hinsichtlich dessen der Intensitätsschwerpunkt des Lichtstrahls eine im Wesentlichen konstante Relativposition beibehalten soll, z.B. die Pyramidenspitze des pyramidenförmigen Prismas gewählt.

Die Erfindung betrifft weiter die Verwendung einer Steuerungseinrichtung mit den vorstehend beschriebenen Merkmalen zur Überwachung eines Anregungs-Laserstrahls in einer EUV-Plasmaquelle.

Weiter betrifft die Erfindung auch ein Verfahren zur Strahlwinkelmessung nach Anspruch 8.

Weitere Ausgestaltungen der Erfindung sind der Beschreibung sowie den Unteransprüchen zu entnehmen. Die Erfindung wird nachstehend anhand von in den beigefügten Abbildungen dargestellten Ausführungsbeispielen näher erläutert.

### KURZE BESCHREIBUNG DER ZEICHNUNGEN

Es zeigen:
- Figur 1: eine schematische Darstellung des prinzipiellen möglichen Aufbaus einer Steuerungseinrichtung für einen Lichtstrahl;
- Figur 2a-2b: schematische Darstellungen zur Erläuterung von Aufbau und Funktionsweise einer Vorrichtung zur Strahlwinkelmessung in einer ersten Ausführungsform;
- Figur 3-6: schematische Darstellungen zur Erläuterung weiterer Ausführungsformen einer Vorrichtung;
- Figur 7: eine schematische Darstellung zur Erläuterung einer herkömmlichen Vorrichtung zur Strahlwinkelmessung; und
- Figur 8: eine schematische Darstellung des prinzipiellen Aufbaus einer EUV-Plasmaquelle.

### DETAILLIERTE BESCHREIBUNG BEVORZUGTER AUSFÜHRUNGSFORMEN

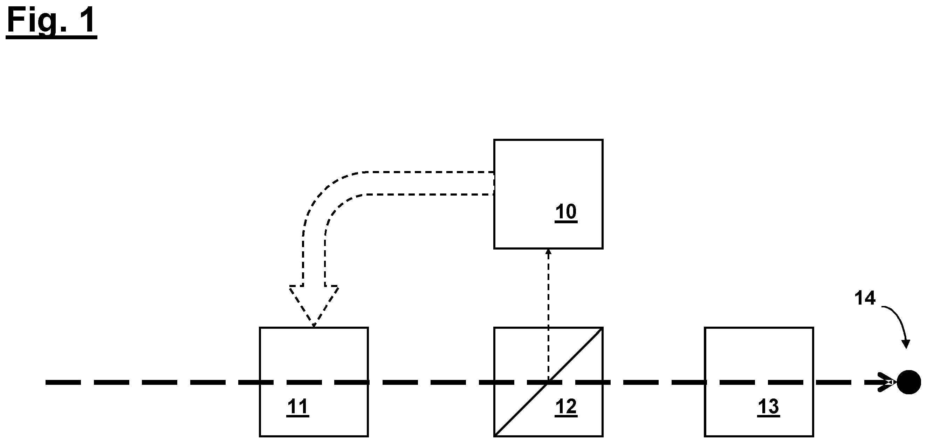

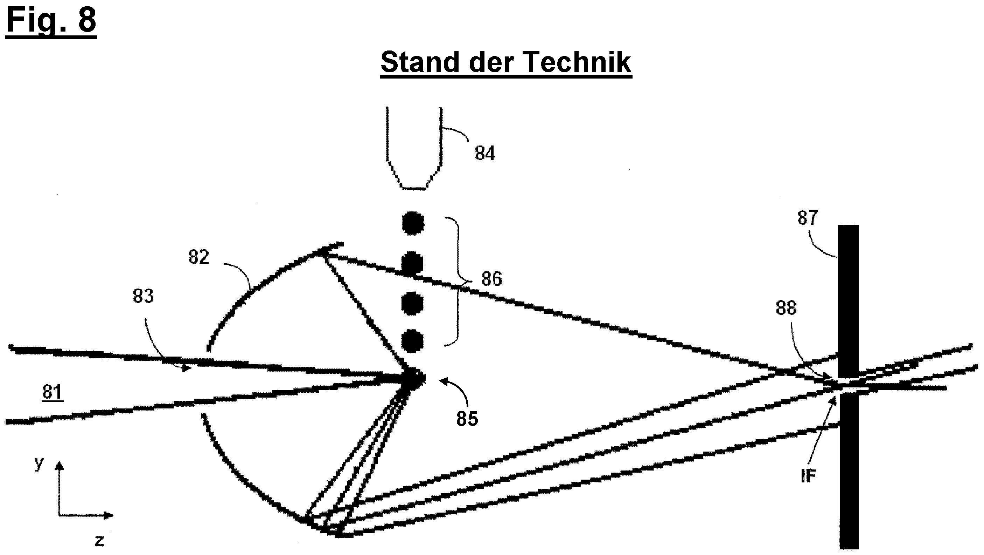

Fig. 1 zeigt zunächst den prinzipiellen Aufbau einer Steuerungseinrichtung für einen Lichtstrahl, welche beispielsweise zur Überwachung und Steuerung eines Anregungs-Laserstrahls in einer unter Bezugnahme auf Fig. 8 noch beschriebenen EUV-Plasmaquelle einsetzbar ist.

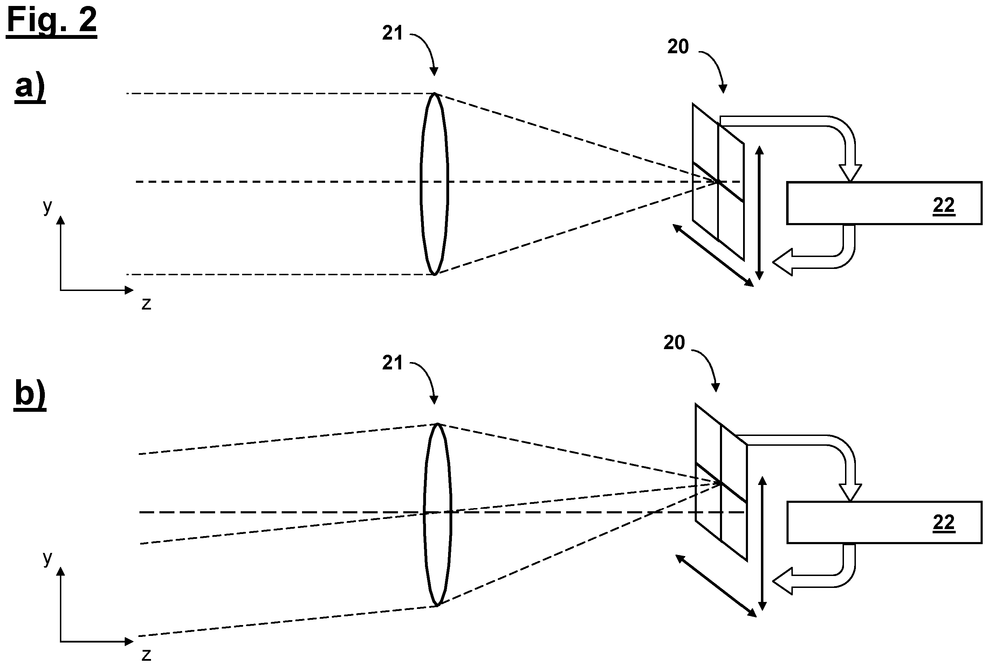

Gemäß Fig. 1 trifft der hinsichtlich seines Strahlwinkels zu charakterisierende und zu kontrollierende Lichtstrahl von einer Strahlführungseinrichtung 11 zunächst auf einen Strahlteiler 12, an welchem ein Messstrahl abgezweigt und einer Vorrichtung 10 zur Strahlwinkelmessung zugeführt wird. Für diese Vorrichtung 10 werden im Folgenden Ausführungsformen unter Bezugnahme auf die schematischen Abbildungen von Fig. 2 bis Fig. 6 beschrieben.

Das von der Vorrichtung 10 gelieferte, für den Strahlwinkel des Lichtstrahls charakteristische Messsignal wird als Regelsignal der Strahlführungsreinrichtung 11 wieder zugeführt, um auf diese Weise vorhandene Störungen in der Position bzw. dem Strahlwinkel des Lichtstrahls herauszuregeln. Gemäß Fig. 1 trifft der nicht über den Strahlteiler 12 abgezweigte Anteil des Lichtstrahls als Arbeitsstrahl über eine Fokussieroptik 13 auf ein Target 14 (z.B. in Form eines Zinntröpfchens in der EUV-Plasmaquelle von Fig. 8).

Im Weiteren werden mögliche Ausführungsformen einer erfindungsgemäßen Vorrichtung zur Strahlwinkelmessung entsprechend der Vorrichtung 10 von Fig. 1 anhand von Fig. 2 bis Fig. 6 beschrieben.

Die Vorrichtung weist dabei jeweils analog zur herkömmlichen Anordnung von Fig. 7 eine Lichtintensitätssensor-Anordnung mit einer Mehrzahl von Lichtintensitätssensoren auf, welche wiederum jeweils als Quadrantendetektor (z.B. Vier-Quadranten-Diode) ausgestaltet ist.

Den Ausführungsformen ist dabei jeweils gemeinsam, dass die "Spotposition" bzw. der Intensitätsschwerpunkt des Lichtstrahls auf besagter Lichtintensitätssensor-Anordnung relativ zu einem vorgegebenen Ort auf der Lichtintensitätssensor-Anordnung (insbesondere relativ zum Zentrum des jeweiligen Quadrantendetektors) nachgeführt bzw. im Wesentlichen konstant gehalten wird.

Gemäß Fig. 2a-2b weist eine Vorrichtung in zum herkömmlichen Aufbau von Fig. 7 analoger Weise eine Lichtintensitätssensor-Anordnung 20 in Form eines Quadrantendetektors auf, welche im Abstand der Brennweite einer Fokussiereinheit 21 angeordnet ist. Mit "22" ist eine Steuereinheit bzw. Nachführeinheit bezeichnet, welche im Ausführungsbeispiel von Fig. 2a-2b in Reaktion auf eine Strahlwinkeländerung durch Manipulation der Position der Lichtintensitätssensor-Anordnung 20 (insbesondere deren Verschiebung in zur Lichtausbreitungsrichtung lateraler Richtung, d.h. innerhalb der x-y-Ebene im eingezeichneten Koordinatensystem) die Relativposition zwischen dem Spot bzw. Auftreffort des Lichtstrahls auf der Lichtintensitätssensor-Anordnung 20 einerseits und deren Zentrum (entsprechend dem "Treffpunkt" der einzelnen Lichtintensitätssensoren des Quadrantendetektors) bis auf eine maximale Abweichung, welche der Hälfte des mittleren Strahldurchmessers beim Auftreffen auf der Lichtintensitätssensor-Anordnung entspricht, beibehält.

Auf diese Weise wird ein im herkömmlichen Aufbau von Fig. 7 bereits bei geringen Strahlwinkeländerungen erfolgendes Herauswandern des Spots aus dem Messbereich des Quadrantendetektors vermieden. Des Weiteren wird das für besagte Nachführung nötige Steuersignal der Nachführeinheit 22 als das für die Strahlwinkeländerung charakteristische Messsignal verwendet. Zusätzlich kann bei der Ermittlung dieses Messsignals auch eine (Rest-) Abweichung des Spots auf der Lichtintensitätssensor-Anordnung 20 d.h. des Quadrantendetektors berücksichtigt werden, da wie bereits vorstehend beschrieben entsprechende hochfrequente Störungen mit vergleichsweise geringer Amplitude zwar nicht über die Nachführung, aber über den Messbereich des Quadrantendetektors selbst erfasst werden können.

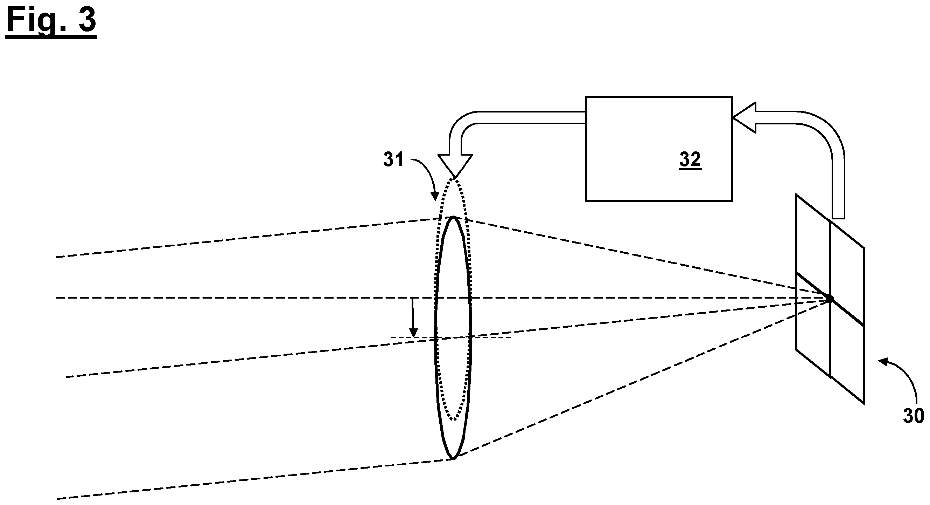

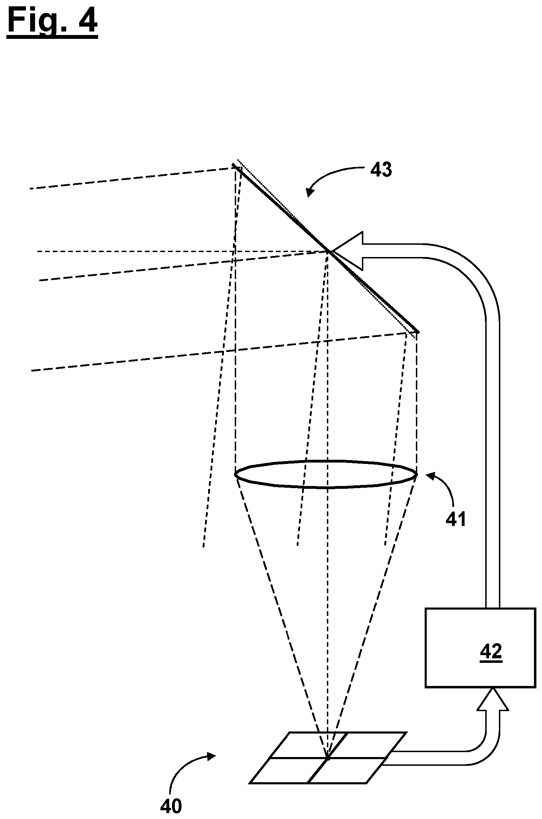

Fig. 3 und Fig. 4 zeigen in schematischer Darstellung weitere mögliche Ausführungsformen einer Vorrichtung, wobei im Vergleich zu Fig. 2a-2b analoge bzw. im Wesentlichen funktionsgleiche Komponenten mit um "10" bzw. "20" erhöhten Bezugsziffern bezeichnet sind.

Dabei unterscheidet sich die Ausführungsform von Fig. 3 von der derjenigen aus Fig. 2a-2b dadurch, dass gemäß Fig. 3 über die Nachführeinheit 32 die Position der Fokussiereinheit 31 manipuliert wird, wodurch im Ergebnis ebenfalls die Relativposition zwischen Intensitätsschwerpunkt bzw. Spot einerseits und Zentrum der Lichtintensitätssensor-Anordnung 30 d.h. des Quadrantendetektors andererseits im Wesentlichen konstant gehalten werden kann.

Gemäß Fig. 4 weist die Vorrichtung im optischen Strahlengang eine zusätzliche Umlenkoptik 43 z.B. in Form eines Ablenkspiegels auf, wobei die Nachführeinheit 42 hier zur Manipulation der Position dieser Umlenkoptik 43 ausgelegt ist.

Zur Realisierung der vorstehend beschriebenen Positionsmanipulationen über die jeweilige Nachführeinheit besonders geeignet sind piezoelektrische Ultraschallantriebe aufgrund ihrer vergleichsweise geringen mechanischen Abmessungen, ihres geringen Gewichts und ihrer vorteilhaften dynamischen Eigenschaften hinsichtlich erreichbarer Geschwindigkeiten und Beschleunigungen. Die Erfindung ist jedoch nicht hierauf beschränkt, so dass zur Positionsmanipulation auch anderweitige Aktoren zur aktiven Nachführung des jeweiligen Elements (d.h. der Lichtintensitätssensor-Anordnung, der Fokussiereinheit und/oder einer Umlenkeinrichtung) insbesondere in Form von Spindelantrieben oder elektromagnetischen Antrieben mit Linearmotoren, Lorenz-Aktoren etc. verwendet werden können.

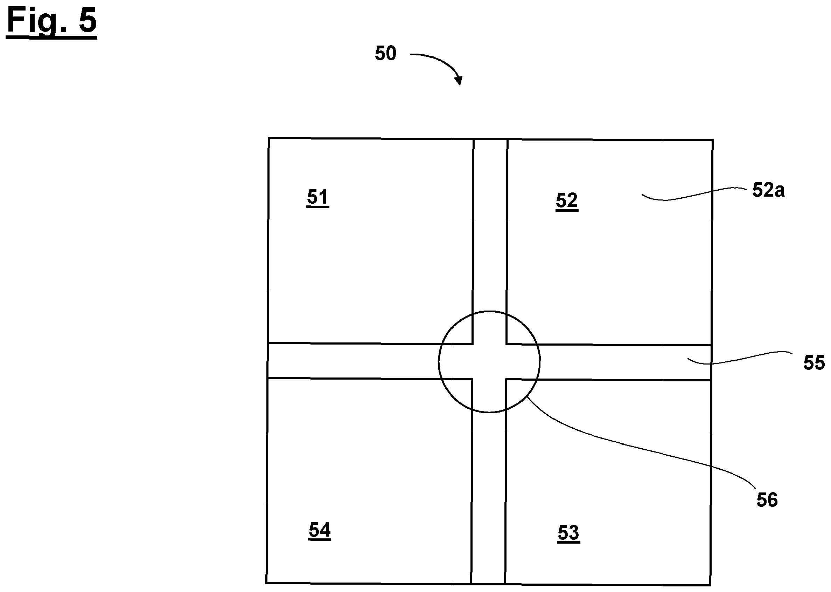

In weiteren Ausführungsformen wird durch geeignete Ausgestaltung der Lichtintensitätssensor-Anordnung dem Vorhandensein fertigungsbedingter Spalte zwischen den einzelnen Lichtintensitätssensoren und dem Umstand Rechnung getragen, dass ohne weitere Maßnahmen ein signifikanter Anteil des hinsichtlich seines Strahlwinkels zu charakterisierenden Lichtstrahls auf diese Spalte trifft und nicht zum Messsignal beiträgt. Zur Veranschaulichung dieser Situation dient die schematische Darstellung von Fig. 5, wobei der verbleibende Spaltbereich zwischen den Lichtintensitätssensoren 51-54 einer Lichtintensitätssensor-Anordnung 50 in Form eines Quadrantendetektors mit "55" bezeichnet ist. Die typischen Spaltdimensionen können größenordnungsmäßig im Bereich von (50-100)µm liegen und wie in Fig. 5 angedeutet eine mit der Größe des Spots des Lichtstrahls 56 vergleichbare Größe aufweisen.

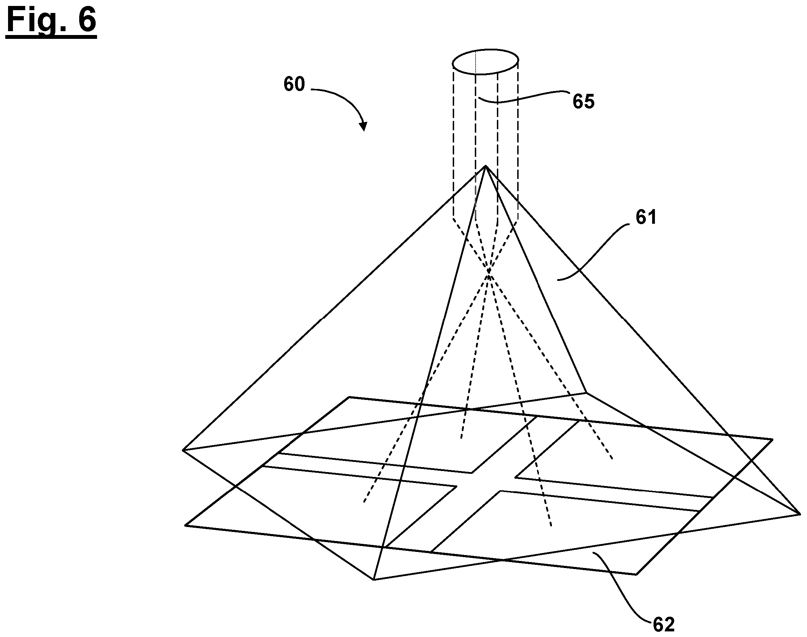

Zur Überwindung dieses Problems weist eine Lichtintensitätssensor-Anordnung 60 in der Ausführungsform von Fig. 6 eine im optischen Strahlengang vorgeschaltete Strahlaufteilungseinrichtung 61 auf, welche im konkreten Ausführungsbeispiel als pyramidenförmiges Prisma ausgestaltet ist und einen auftreffenden, als Strahlröhre 65 dargestellten Lichtstrahl auf die einzelnen Lichtintensitätssensoren 62 aufteilt. Da die Kanten des die Strahlaufteilungseinrichtung 61 ausbildenden Prismas randscharf (typischerweise auf Randschärfen von weniger als 1µm) poliert werden können, werden demzufolge die vorstehend beschriebenen Lichtverluste vermieden und die gesamte Intensität des Lichtstrahls wird bei der erfindungsgemäßen Messung genutzt.

Fig. 8 zeigt als mögliche Anwendung der Erfindung einen herkömmlichen Aufbau einer Laserplasmaquelle z.B. zur Anwendung in der Lithographie zur Erzeugung des benötigten EUV-Lichtes einer für den EUV-Bereich (z.B. bei Wellenlängen von z.B. etwa 13nm oder etwa 7nm) ausgelegten Projektionsbelichtungsanlage.

Diese EUV-Lichtquelle weist einen (nicht gezeigten) Hochenergielaser z.B. zur Erzeugung von Infrarotstrahlung 81 (z.B. CO₂-Laser mit einer Wellenlänge von λ≈ 10.6µm) auf, welche über eine Fokussieroptik fokussiert wird, durch eine in einem als Ellipsoid ausgebildeten Kollektorspiegel 82 vorhandene Öffnung 83 hindurchtritt und als Anregungsstrahl auf ein mittels einer Targetquelle 84 erzeugtes und einer Plasmazündungsposition 85 zugeführtes Targetmaterial 86 (z.B. Zinntröpfchen) gelenkt wird. Die Infrarotstrahlung 81 heizt das in der Plasmazündungsposition 85 befindliche Targetmaterial 86 derart auf, dass dieses in einen Plasmazustand übergeht und EUV-Strahlung abgibt. Diese EUV-Strahlung wird über den Kollektorspiegel 82 auf einen Zwischenfokus IF (= "Intermediate Focus") fokussiert und tritt durch diesen in eine nachfolgende Beleuchtungseinrichtung, deren Umrandung 87 lediglich angedeutet ist und die für den Lichteintritt eine freie Öffnung 88 aufweist, ein.

Von wesentlicher Bedeutung für die in einer EUV-Lichtquelle bzw. Laserplasmaquelle erzielbare Dosisstabilität bzw. zeitliche Stabilität der EUV-Abstrahlcharakteristik und die realisierbare EUV-Lichtausbeute ist dabei, dass die mit zunehmendem Lichtbedarf sehr schnell (z.B. mit einer Injektionsrate im Bereich von 100kHz bzw. in einem zeitlichen Abstand von z.B. 10µs) in die Laserplasmaquelle "einfliegenden" Zinntröpfchen individuell hochgenau (z.B. mit einer Genauigkeit unterhalb von 1µm) und reproduzierbar von dem das Tröpfchen zerstäubenden Laserstrahl getroffen werden. Dies erfordert im o.g. Aufbau wiederum eine hochgenaue Einstellung der Tröpfchenposition sowie eine hochgenaue Nachführung der z.B. vom CO₂-Laser erzeugten Infrarotstrahlung 83. Die erfindungsgemäße Steuerungseinrichtung kann somit zur Überwachung bzw. Strahlwinkelmessung des entsprechenden durch den CO₂-Laser erzeugten Anregungsstrahls in dem bereits anhand von Fig. 1 beschriebenen Aufbau genutzt werden.

## Patentansprüche

1. Steuerungseinrichtung für einen Lichtstrahl, mit
• einer Strahlführungseinrichtung (11) zur Führung eines Lichtstrahls;
• einem Strahlteiler (12) zur Aufteilung dieses Lichtstrahls in einen abgezweigten Messstrahl und einen nicht abgezweigten Arbeitsstrahl; und
• einer Vorrichtung (10) zur Strahlwinkelmessung, wobei der Strahlteiler (12) dazu konfiguriert ist, den abgezweigten Messstrahl der Vorrichtung (10) zuzuführen,
wobei die Vorrichtung (10) zur Strahlwinkelmessung aufweist:
- eine Lichtintensitätssensor-Anordnung (20, 30, 40, 50, 60), welche eine Mehrzahl von Lichtintensitätssensoren aufweist;
- eine Fokussiereinheit (21, 31, 41) zum Fokussieren des abgezweigten Messstrahls auf einen vorgegebenen Ort auf der Lichtintensitätssensor-Anordnung (20, 30, 40, 50, 60);
- wobei die Lichtintensitätssensor-Anordnung (20, 30, 40, 50, 60) ein Quadrantendetektor ist, wobei der vorgegebene Ort auf der Lichtintensitätssensor-Anordnung (20, 30, 40, 50, 60) dem Zentrum dieses Quadrantendetektors entspricht; und
- eine Nachführeinheit (22, 32, 42);
**dadurch gekennzeichnet, dass**
- die Nachführeinheit (22, 32, 42) dazu konfiguriert ist, durch aktive Nachführung einer im Strahlengang des abgezweigten Messstrahls nach dem Strahlteiler (12) befindlichen Komponente der Vorrichtung (10) basierend auf von den Lichtintensitätssensoren der Lichtintensitätssensor-Anordnung (20, 30, 40, 50, 60) gemessenen Lichtintensitäten über eine Nachführung der Relativposition des Intensitätsschwerpunkts des abgezweigten Messstrahls in Bezug auf den vorgegebenen Ort auf der Lichtintensitätssensor-Anordnung (20, 30, 40, 50, 60) diese Relativposition bei Änderung des bei Eintritt des abgezweigten Messtrahls in die Vorrichtung (10) vorliegenden Strahlwinkels des Messstrahls bis auf eine vorgegebene maximale Abweichung, welche der Hälfte des mittleren Strahldurchmessers des Messstrahls beim Auftreffen auf der Lichtintensitätssensor-Anordnung (20, 30, 40, 50, 60) entspricht, konstant zu halten;
- wobei die Vorrichtung (10) dazu konfiguriert ist, ein zur Nachführung jeweils benötigtes Steuersignal als für den Strahlwinkel des Lichtstrahls charakteristisches Messsignal zu liefern und der Strahlführungseinrichtung (11) als Regelsignal zuzuführen, so dass Störungen im Strahlwinkel des Lichtstrahls herausregelbar sind.

2. Steuerungseinrichtung nach Anspruch 1, **dadurch gekennzeichnet, dass** die Nachführeinheit (22, 32, 42) wenigstens einen Manipulator zum Manipulieren der Position der Lichtintensitätssensor-Anordnung (20, 30, 40, 50, 60) und/oder der Fokussiereinheit (21, 31, 41) aufweist.

3. Steuerungseinrichtung nach Anspruch 1 oder 2, **dadurch gekennzeichnet, dass** die Vorrichtung (10) wenigstens eine Umlenkoptik (43) zum Umlenken des abgezweigten Messtrahls vor Auftreffen auf die Lichtintensitätssensor-Anordnung (40) aufweist, wobei die Nachführeinheit (42) wenigstens einen Manipulator zum Manipulieren des Kippwinkels und/oder der Position dieser Umlenkoptik (43) aufweist.

4. Steuerungseinrichtung nach einem der vorhergehenden Ansprüche, **dadurch gekennzeichnet, dass** der vorgegebene Ort auf der Lichtintensitätssensor-Anordnung (20, 30, 40, 50, 60) jeweils an diese Lichtintensitätssensoren angrenzt.

5. Steuerungseinrichtung nach einem der vorhergehenden Ansprüche, **dadurch gekennzeichnet, dass** die Lichtintensitätssensor-Anordnung (60) eine Strahlaufteilungseinrichtung (61) zum Aufteilen des Messtrahls auf die Lichtintensitätssensoren aufweist.

6. Steuerungseinrichtung nach Anspruch 5, **dadurch gekennzeichnet, dass** die Strahlaufteilungseinrichtung (61) wenigstens ein Prisma aufweist.

7. Verwendung einer Steuerungseinrichtung nach einem der vorhergehenden Ansprüche zur Überwachung und Steuerung eines Anregungs-Laserstrahls in einer Plasmaquelle zur Erzeugung von Licht im Extremen Ultraviolett (EUV)-Bereich.

8. Verfahren zur Strahlwinkelmessung,
- wobei ein von einer Strahlführungseinrichtung (11) geführter Lichtstrahl über einen Strahlteiler (12) in einen abgezweigten Messstrahl und einen nicht abgezweigten Arbeitsstrahl aufgeteilt wird;
- wobei der abgezweigte Messstrahl einer Vorrichtung (10) zur Strahlwinkelmessung zugeführt wird und auf einen vorgegebenen Ort einer in dieser Vorrichtung (10) vorhandenen Lichtintensitätssensor-Anordnung (20, 30, 40, 50, 60) fokussiert wird, wobei die Lichtintensitätssensor-Anordnung (20, 30, 40, 50, 60) eine Mehrzahl von Lichtintensitätssensoren aufweist;
- wobei die Lichtintensitätssensor-Anordnung (20, 30, 40, 50, 60) ein Quadrantendetektor ist, wobei der vorgegebene Ort auf der Lichtintensitätssensor-Anordnung (20, 30, 40, 50, 60) dem Zentrum dieses Quadrantendetektors entspricht;
**dadurch gekennzeichnet, dass**
- eine Relativposition des Intensitätsschwerpunkts des abgezweigten Messstrahls in Bezug auf einen vorgegebenen Ort auf der Lichtintensitätssensor-Anordnung (20, 30, 40, 50, 60) bei Änderung des bei Eintritt des abgezweigten Messtrahls in die Vorrichtung (10) vorliegenden Strahlwinkels durch aktive Nachführung einer im Strahlengang des abgezweigten Messstrahls nach dem Strahlteiler (12) befindlichen Komponente der Vorrichtung (10) nachgeführt wird,
- wobei als für die Strahlwinkelmessung relevantes und von der Vorrichtung (10) geliefertes Messsignal ein zur Nachführung jeweils benötigtes Steuersignal herangezogen wird.

## Claims

1. Control device for a light beam, comprising
• a beam guiding device (11) for guiding a light beam;
• a beam splitter (12) for splitting this light beam into a diverted measurement beam and a non-diverted working beam; and
• an apparatus (10) for beam angle measurement, wherein the beam splitter (12) is configured to feed the diverted measurement beam to the apparatus (10),
wherein the apparatus (10) for beam angle measurement comprises:
- a light intensity sensor arrangement (20, 30, 40, 50, 60) comprising a plurality of light intensity sensors;
- a focusing unit (21, 31, 41) for focusing the diverted measurement beam at a specified location on the light intensity sensor arrangement (20, 30, 40, 50, 60);
- wherein the light intensity sensor arrangement (20, 30, 40, 50, 60) is a quadrant detector, with the specified location on the light intensity sensor arrangement (20, 30, 40, 50, 60) corresponding to the centre of this quadrant detector; and
- an adjustment unit (22, 32, 42);
**characterized in that**
- the adjustment unit (22, 32, 42) is configured, by active adjustment of a component of the apparatus (10) that is situated downstream of the beam splitter (12) in the beam path of the diverted measurement beam, on the basis of light intensities measured by the light intensity sensors of the light intensity sensor arrangement (20, 30, 40, 50, 60), by way of an adjustment of the relative position of the intensity centroid of the diverted measurement beam in relation to the specified location on the light intensity sensor arrangement (20, 30, 40, 50, 60), to keep this relative position constant up to a specified maximum deviation when there is a change in the beam angle of the diverted measurement beam present upon entry of the measurement beam in the apparatus (10), said maximum deviation corresponding to half the mean beam diameter of the measurement beam upon incidence on the light intensity sensor arrangement (20, 30, 40, 50, 60);
and
- wherein the apparatus (10) is configured to supply a control signal respectively required for adjustment purposes as a measurement signal characteristic of the beam angle of the light beam and to feed said control signal to the beam guiding device (11) as a closed-loop control signal,
such that disturbances in the beam angle of the light beam can be removed by closed-loop control.

2. Control device according to Claim 1, **characterized in that** the adjustment unit (22, 32, 42) comprises at least one manipulator for manipulating the position of the light intensity sensor arrangement (20, 30, 40, 50, 60) and/or of the focusing unit (21, 31, 41).

3. Control device according to Claim 1 or 2, **characterized in that** the apparatus (10) comprises at least one deflection optical unit (43) for deflecting the diverted measurement beam prior to the incidence on the light intensity sensor arrangement (40), wherein the adjustment unit (42) comprises at least one manipulator for manipulating the tilt angle and/or the position of this deflection optical unit (43).

4. Control device according to any of the preceding claims, **characterized in that** the specified location on the light intensity sensor arrangement (20, 30, 40, 50, 60) in each case adjoins these light intensity sensors.

5. Control device according to any of the preceding claims, **characterized in that** the light intensity sensor arrangement (60) comprises a beam splitter device (61) for splitting the measurement beam among the light intensity sensors.

6. Control device according to Claim 5, **characterized in that** the beam splitter device (61) comprises at least one prism.

7. Use of a control device according to any of the preceding claims for monitoring and controlling an excitation laser beam in a plasma source for generating light in the extreme ultraviolet (EUV) range.

8. Method for beam angle measurement,
- wherein a light beam guided by a beam guiding device (11) is split via a beam splitter (12) into a diverted measurement beam and a non-diverted working beam;
- wherein the diverted measurement beam is fed to an apparatus (10) for beam angle measurement and is focused onto a specified location of a light intensity sensor arrangement (20, 30, 40, 50, 60) present in this apparatus (10), wherein the light intensity sensor arrangement (20, 30, 40, 50, 60) comprises a plurality of light intensity sensors;
- wherein the light intensity sensor arrangement (20, 30, 40, 50, 60) is a quadrant detector, with the specified location on the light intensity sensor arrangement (20, 30, 40, 50, 60) corresponding to the centre of this quadrant detector;
**characterized in that**
- a relative position of the intensity centroid of the diverted measurement beam in relation to a specified location on the light intensity sensor arrangement (20, 30, 40, 50, 60), when there is a change in the beam angle present upon entry of the diverted measurement beam in the apparatus (10), is adjusted by active adjustment of a component of the apparatus (10) that is situated downstream of the beam splitter (12) in the beam path of the diverted measurement beam,
- wherein a control signal respectively required for adjustment purposes is used as a measurement signal that is relevant for the beam angle measurement and supplied by the apparatus (10).

## Revendications

1. Dispositif de commande pour un faisceau lumineux, comprenant
• un dispositif (11) de guidage de faisceau pour guider un faisceau lumineux ;
• un diviseur de faisceau (12) pour diviser ce faisceau lumineux en un faisceau de mesure dévié et un faisceau de travail non dévié ; et
• un dispositif (10) pour mesurer l'angle du faisceau, le diviseur de faisceau (12) étant configuré pour acheminer le faisceau de mesure dévié vers le dispositif (10),
le dispositif (10) pour mesurer l'angle du faisceau comprenant :
- un agencement (20, 30, 40, 50, 60) de capteurs d'intensité lumineuse qui comprend une pluralité de capteurs d'intensité lumineuse ;
- une unité de focalisation (21, 31, 41) pour focaliser le faisceau de mesure dévié sur un emplacement prédéfini sur l'agencement (20, 30, 40, 50, 60) de capteurs d'intensité lumineuse ;
- l'agencement (20, 30, 40, 50, 60) de capteurs d'intensité lumineuse étant un détecteur à quadrants, l'emplacement prédéterminé sur l'agencement (20, 30, 40, 50, 60) de capteurs d'intensité lumineuse correspondant au centre de ce détecteur à quadrants ; et
- une unité de suivi (22, 32, 42) ;
**caractérisé en ce que**
- l'unité de suivi (22, 32, 42) est conçue pour maintenir constante, par suivi actif d'un composant du dispositif (10) situé dans le trajet optique du faisceau de mesure dévié en aval du diviseur de faisceaux (12) en fonction des intensités lumineuses mesurées par les capteurs d'intensité lumineuse de l'agencement (20, 30, 40, 50, 60) de capteurs d'intensité lumineuse par un suivi de la position relative du centre d'intensité du faisceau de mesure dévié par rapport à l'emplacement prédéfini sur l'agencement (20, 30, 40, 50, 60) de capteurs d'intensité lumineuse, cette position relative en cas de modification de l'angle du faisceau de mesure présent à l'entrée du faisceau de mesure dévié dans le dispositif (10) jusqu'à un écart maximal prédéfini qui correspond à la moitié du diamètre moyen du faisceau de mesure lors de l'impact sur l'agencement (20, 30, 40, 50, 60) de capteurs d'intensité lumineuse ;
et
- le dispositif (10) étant conçu pour délivrer un signal de commande nécessaire au suivi sous forme de signal de mesure caractéristique de l'angle du faisceau lumineux et pour le transmettre au dispositif (11) de guidage de faisceau en tant que signal de commande,
de sorte que des perturbations dans l'angle du faisceau lumineux peuvent être éliminées.

2. Dispositif de commande selon la revendication 1, **caractérisé en ce que** l'unité de suivi (22, 32, 42) comprend au moins un manipulateur pour manipuler la position de l'agencement (20, 30, 40, 50, 60) de capteurs d'intensité lumineuse et/ou de l'unité de focalisation (21, 31, 41).

3. Dispositif de commande selon la revendication 1 ou la revendication 2, **caractérisé en ce que** le dispositif (10) comprend au moins un système optique de déviation (43) pour dévier le faisceau de mesure dévié avant qu'il ne rencontre l'agencement (40) de capteurs d'intensité lumineuse, l'unité de suivi (42) comprenant au moins un manipulateur pour manipuler l'angle d'inclinaison et/ou la position de cette optique de déviation (43).

4. Dispositif de commande selon l'une des revendications précédentes, **caractérisé en ce que** l'emplacement prédéfini sur l'agencement (20, 30, 40, 50, 60) de capteurs d'intensité lumineuse est adjacent à ces capteurs d'intensité lumineuse.

5. Dispositif de commande selon l'une des revendications précédentes, **caractérisé en ce que** l'agencement (60) de capteurs d'intensité lumineuse comprend un dispositif (61) de répartition de faisceau pour répartir le faisceau de mesure sur les capteurs d'intensité lumineuse.

6. Dispositif de commande selon la revendication 5, **caractérisé en ce que** le dispositif (61) de répartition de faisceau comprend au moins un prisme.

7. Utilisation d'un dispositif de commande selon l'une des revendications précédentes pour surveiller et commander un faisceau laser d'excitation dans une source de plasma en vue de générer de la lumière dans la gamme des ultraviolets extrêmes (EUV).

8. Procédé de mesure de l'angle d'un faisceau,
- dans lequel un faisceau lumineux guidé par un dispositif (11) de guidage de faisceau est divisé par un diviseur de faisceau (12) en un faisceau de mesure dévié et un faisceau de travail non dévié ;
- le faisceau de mesure dévié étant amené à un dispositif (10) de mesure de l'angle du faisceau et étant focalisé sur un emplacement prédéfini d'un agencement (20, 30, 40, 50, 60) de capteurs d'intensité lumineuse présent dans ce dispositif (10), l'agencement (20, 30, 40, 50, 60) de capteurs d'intensité lumineuse comprenant une pluralité de capteurs d'intensité lumineuse ;
- **l'agencement** (20, 30, 40, 50, 60) de capteurs d'intensité lumineuse est un détecteur à quadrants, l'emplacement prédéfini sur l'agencement (20, 30, 40, 50, 60) de capteurs **d'intensité** lumineuse correspondant au centre de ce détecteur à quadrants ;
**caractérisé en ce que**
- une position relative du centre du faisceau de mesure dévié par rapport à un emplacement prédéfini sur l'agencement (20, 30, 40, 50, 60) de capteurs d'intensité lumineuse est suivie lors de la modification de l'angle de faisceau présent lors de l'entrée du faisceau de mesure dévié dans le dispositif (10), par un suivi actif d'un composant du dispositif (10) situé dans le trajet du faisceau de mesure dévié après le diviseur de faisceau (12),
- un signal de commande nécessaire au suivi étant utilisé en tant que signal de mesure pertinent pour la mesure de l'angle de faisceau et fourni par le dispositif (10).
